Europäisches Patentamt

European Patent Office

Office européen des brevets

(11) Veröffentlichungsnummer: 0 179 159
A1

## (12) EUROPÄISCHE PATENTANMELDUNG

(21) Anmeldenummer: 84112687.3

(22) Anmeldetag: 20.10.84

(51) Int. Cl.⁴: G 06 F 13/40
H 05 K 5/04

(43) Veröffentlichungstag der Anmeldung:
30.04.86 Patentblatt 86/18

(84) Benannte Vertragsstaaten:
AT BE CH DE FR GB IT LI LU NL SE

(71) Anmelder: Honeywell Bull (Schweiz) AG
Wengistrasse 28
CH-8021 Zürich(CH)

(72) Erfinder: Moser, Roland
Bergstrasse 32
CH-8108 Dällikon(CH)

(72) Erfinder: Zweifel, Erich
Im Faad 13
CH-8718 Schänis(CH)

(74) Vertreter: Maspoli, Renato A., Dipl.-Chem.Ing.ETH
Patentanwälte R.A. Maspoli und Partner
Promenadengasse 18
CH-8001 Zürich(CH)

(54) Adaptersystem für Datenübertragungsverbindung.

(57) Das neue Adaptersystem zur Herstellung einer gesicherten Datenübertragungsverbindung zwischen Zentralcomputer und Peripheriegeräten – hauptsächlich Terminals – basiert auf der neuartigen Aufteilung der Verbindungsleitung zwischen Systemkabelstecker und Termialkabelstecker in eine Hausinstallation mit beidseitig gleichen Anschlüssen und einem Adapter, in dem die Auskreuzung der Anschlüsse bewerkstelligt wird. Der genannte Adapter, der der Hausinstallation vorgeschaltet wird, ist genau auf das Peripheriegerät abgestimmt und fest verkabelt. Die Kabelzugänge und die Steckerausgänge sind auf die gedruckte Schaltung des Adapters aufgelötet. Adapter und System- bzw. Hausinstallationsstecker sind in Universalgehäuse untergebracht, die sowohl eine übersichtliche Installation wie auch eine vereinfachte Herstellung und Lagerhaltung erlauben.

Fig. 6

## ADAPTERSYSTEM ZUR HERSTELLUNG EINER
## GESICHERTEN DATENUEBERTRAGUNGSVERBINDUNG

Die vorliegend beschriebene Erfindung betrifft ein neuartiges
Adaptersystem zur Herstellung einer gesicherten Datenübertragungsverbindung zwischen einem oder mehreren Zentralcomputer(n)
und mehreren Peripherie-, speziell Terminalgeräten.

Die Aufstellung von peripher angelegten EDV-Anlagen, d.h. von
Anlagen mit einem oder mehreren Zentralcomputern und mit damit
verbundenen Peripheriegeräten, oft auch Terminals genannt,
ist heute schon sehr verbreitet. Derartige Anlagen werden,
nach Ansicht von darin spezialisierten Fachleuten, sowohl an
Anzahl wie auch an Komplexität in den nächsten Jahrzehnten
noch zunehmen.

Währenddem nun sowohl die Zentraleinheiten mit ihren Ausgängen
wie auch die Peripheriegeräte mit entsprechenden Eingängen hinsichtlich Herstellung und Installation einen sicherheitsmässig genügend hohen Grad erreichen, trifft dies für die verschiedenen Verbindungen zwischen den beiden genannten Anlagenteilen zur Zeit aus mindestens drei Gründen nicht immer zu:

- Typ und Leistung, sowohl von Zentralcomputer wie auch von
  Peripheriegerät, sind meistens, bezogen auf eine bestimmte
  Gesamtanlage, verschieden und können zudem relativ rasch
  ändern. Dadurch werden jedesmal spezielle und verschiedene
  Verbindungen benötigt.

- Die Distanzen zwischen Zentrale und Peripheriegerät sind
  praktisch ebenfalls von Anlage zu Anlage verschieden und
  können sich kurzfristig ändern. Die Art der Datenübertragungsverbindung ist nun aber auch von der Distanz abhängig; sie
  muss also auch diesbezüglich jedesmal anders ausgeführt bzw.
  angepasst werden.

- Die Verbindung zwischen Computer und Peripheriegerät wird
  im allgemeinen von Elektroinstallateuren erstellt, die

  - bezüglich Datenübertragung oft keine umfassenden Erfahrungen
    besitzen,

  - mit ungewohnten Schaltungsunterlagen arbeiten müssen,

  - nicht immer über geeignetes Werkzeug verfügen und

  - mit Verbindungsarten und -elementen konfrontiert werden,
    wie sie in ihrem angestammten Bereich nicht üblich sind.

  Dadurch besteht die Gefahr von Fehlverbindungen, die ausserordentlich schwer zu lokalisieren und zu beheben sind.

Die EDV-Industrie hat speziell den zuletzt aufgeführten Installationsschwierigkeiten zwar dadurch Rechnung getragen, dass sie eine Zahl von Handbüchern zur Installation speziell von Terminals herausgegeben hat. Dadurch wurden die Probleme aber naturgemäss lediglich aufgelistet - nicht gelöst. Beispielsweise existiert ein derartiges Handbuch, speziell für den Anschluss von Terminals an einen Zentralcomputer, welches auf 126 Seiten etwa 35 verschiedene Anschlussverbindungen und über 50 (durch den Hausinstallateur zu verlötende) Systemkabel mit je 25 Polen in den Steckern darlegt und spezifiziert.

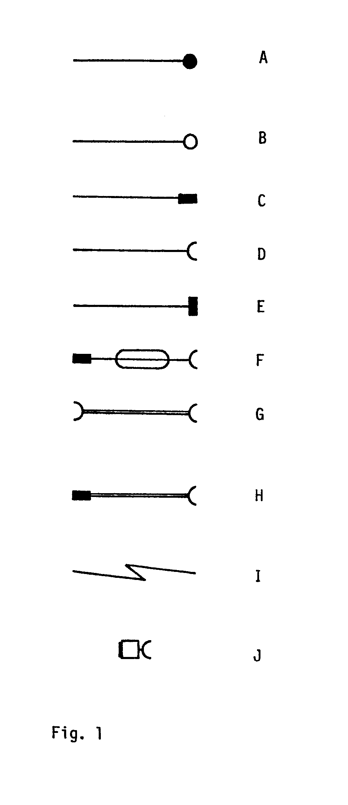

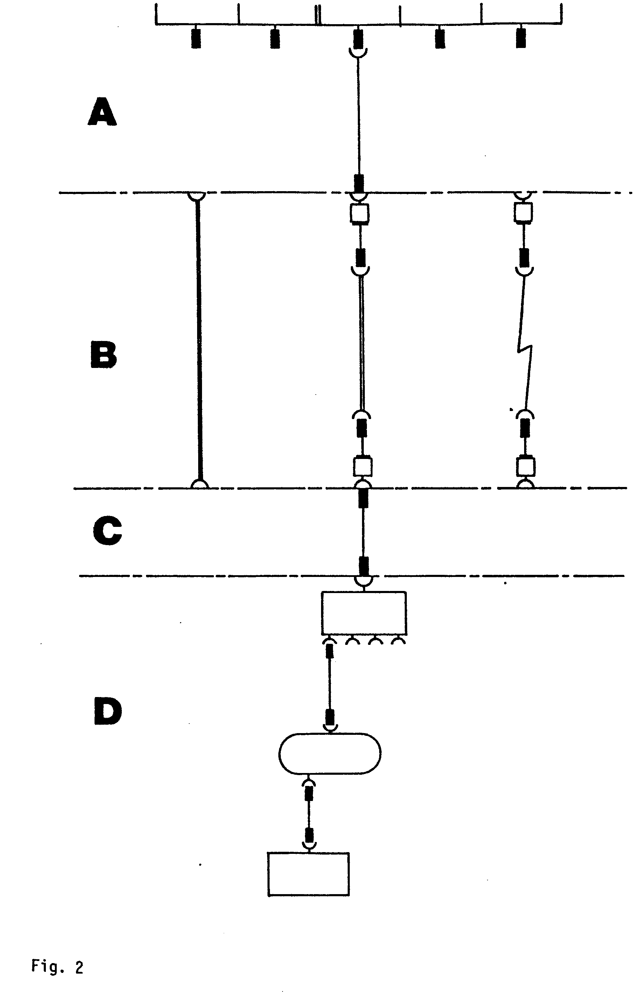

Die Symbole, die für derartige Installationen - immer gemäss dem genannten Handbuch - verwendet werden sowie ein Beispiel für einen Installationsplan für einen Terminal sind dieser Beschreibung als Figur 1 bzw. Figur 2 beigelegt. In Figur 1 stehen

A für: Nicht lösbare Kabelverbindung terminal- oder systemintern

B für: Lösbare Kabelverbindung terminal- oder systemintern,

C für: Steckerstifte einer lösbaren Verbindung,

D für: Steckerbuchse einer lösbaren Verbindung,

E für: Spezialstecker einer lösbaren Verbindung,

F für: Adapterkaben,

G für: fixe Installation, beidseitig Steckerbuchsen,

H für: fixe Installation, einseitig Steckerstifte, anderseitig Steckerbuchsen,

I für: 2- oder 4-drähtige Verbindung und

J für: Datenübertragungseinrichtung.

Bei der Figur 2 ist zu beachten, dass A der Abschnitt des Ausganges auf dem Zentralcomputer und D der Abschnitt mit dem Eingang

4 ⌐ ⌐ ⌐ ⌐ ⌐ ⌐                    0179159

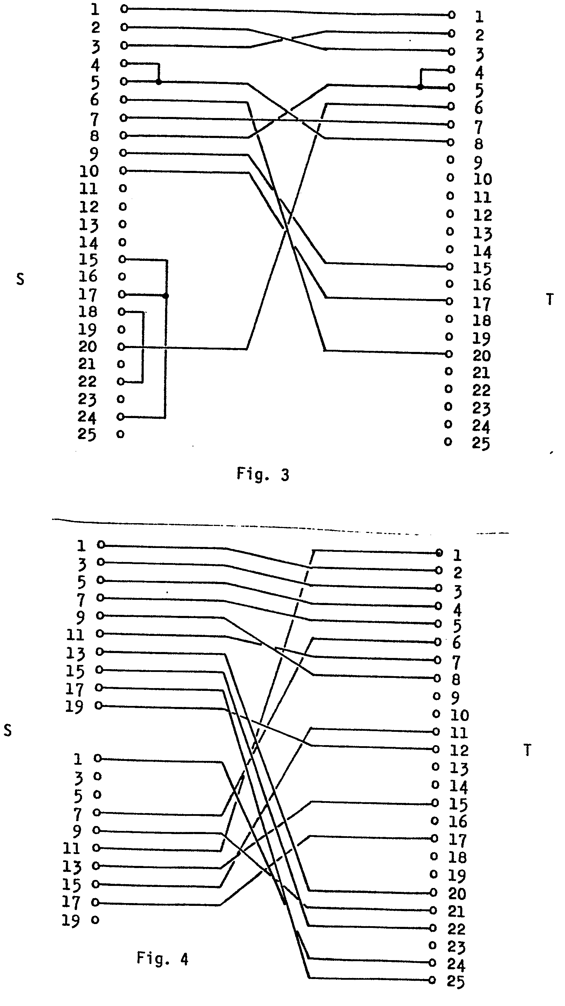

in den Terminal bedeuten. Zur Erläuterung der Komplexität der
verschiedenen Systemkabel dienen die Darstellungen in den ebenfalls beigelegten Figuren 3 und 4. Darin steht

S für: die System-Seite und

T für: die Terminal-Seite.


Zusammenfassend kann gesagt werden, dass die Verbindungs- und
Installationstechnologie nicht ganz mit derjenigen der Zentralcomputer und Peripheriegeräte Schritt gehalten hat.


Es war daher selbst für den Fachmann auf diesem Gebiet überraschend, dass viele der oben aufgeführten Probleme durch eine
von früheren Installationen verschiedene Konzeption der Verbindung zwischen Computer und Peripheriegerät grundsätzlich gelöst
werden konnten. Die genannte Konzeption beruht auf einem neuartigen Adaptersystem, welches erlaubt, die gesamte Verbindungsstrecke zwischen Computer und Peripheriegerät eindeutiger in
eigentliche Hausinstallationen mit üblichen Mitteln und in
Adapterfunktionen aufzuteilen. Dass dadurch auch etliche rechtliche Schwierigkeiten (Garantiegrenzen) aus der Welt geschafft
werden konnten, sei nur am Rand erwähnt.


Das erfindungsgemässe Adaptersystem zur Herstellung einer gesicherten Datenübertragungsverbindung zwischen Zentralcomputer
und Peripheriegerät, bestehend im wesentlichen aus Gerätestecker
auf Seite Hausinstallation, aus Steckdose auf Seite Computer
sowie, im üblichen Falle, aus Adapter zwischen den beiden genannten Elementen ist dadurch gekennzeichnet, dass Steckdosen-
und Adapterelement in einem Gehäuse untergebracht sind, welches in zwei der drei Raumdimensionen in allen Fällen klassengleich und in der dritten Dimension variabel ist, dass Steckdosen- und Adaptergehäuse verschiedene Datenstecker bzw. -steckdosen aufnehmen, dass der Adapter derart in die Hausinstallation eingebaut wird, dass er vorgeschaltet bzw. vorgesteckt wird, dass der Adapter genau auf das Peripheriegerät abgestimmt und fest verkabelt ist und beidseitig Datenstecker/-steckdose aufweist und dass die im System verwendeten Stecker bzw. Steckdosen über eine gedruckte Schaltung mittels Löten an Kabeln angeschlossen werden.

Im genannten Adaptersystem bestehen Steckdosen- und Adaptergehäuse üblicherweise aus zwei galvanisierbaren Kunststoffschalen, die mittels Distanzblechen in verschiedenen Breiten fixiert werden, wodurch der Einbau von weiteren Elektronik-Bauelementen ermöglicht wird.

Die genannten Elementgehäuse können elektrisch abgeschirmt ausgeführt sein.

Im obigen Adaptersystem können die Gehäuse von Steckdose Seite Computer und von Adapter derart ausgebildet sein, dass sie einzeln oder in Serien entweder an der Wand, in waagrechten oder senkrechten Schienen oder, bei Bedarf, auch in Aufputz- oder Unterputzmontage angebracht bzw. verschraubt oder eingeklemmt werden können.

Verwendet wird das neue Adaptersystem zur Herstellung von Datenübertragungsverbindungen in gebäudeinternen oder -externen EDV-Anlagen zwischen einem oder mehreren Zentralcomputern und mehreren Terminalgeräten.

Durch das Prinzip der Aufteilung der Verbindungsstrecke in Adapter und Hausinstallation gelingt es, die Hausinstallation für ein bestimmtes Schnittstellenprinzip immer in derselben Art zu erstellen.Eine Hausinstallation wird damit denkbar einfach und für den Installateur leicht und sicher ausführbar.

Die Anpassung zwischen Computer und Anschlussgerät ist vom Gerätetyp abhängig und deshalb sehr verschiedenartig; die genannte Anpassung wird mit einem Anpassungsglied (Adapter) bewerkstelligt.

Aus diesem einfachen Prinzip ergeben sich folgende Anforderungen an die Verbindungselemente:

- Für alle Hausinstallationen soll derselbe Steckertyp verwendet werden. Die Verbindung soll gelötet werden und auch von unerfahrenen Personen leicht zu realisieren sein.

- Anpassungsfunktionen sollen auf einfache Weise in die Hausinstallation eingebaut werden können. Z.B. soll der Adapter vorgeschaltet (vorgesteckt) werden.

- Adapter sind fest verkabelt und auf die Geräte abgestimmt. Es sind keinerlei Aenderungen vorzunehmen.

- Alle Adapter und Steckeinheiten werden in einem Universalgehäuse untergebracht, das für alle Anwendungen gleich ist.

- Alle Einheiten können in verschiedenen Lagen montiert werden. Wo Kabeleinführungen nötig sind, ist der Kabelzugang aus mindestens zwei Richtungen möglich.

- Die Steckergehäuse sind so konzipiert, dass sie alle heute
  verwendeten Datensteckertypen aufnehmen und damit auch in
  Installationen Verwendung finden können, die verschiedene
  Produkte betreffen.

- Die Steckergehäuse können mit einer Abschirmung versehen
  werden.

- Der erfindungsgemässe Adapter besteht aus zwei galvanisierbaren Plastikschalen, welche die verschiedensten Datensteckertypen aufnehmen können. Die sonst schwer zu lötenden Datenstecker sind mit einer gedruckten Schaltung verlötet.

Das direkte Verlöten des Kabels mit dem Stecker bietet für
die Installateure Probleme.

Aus diesem Grund wird der Stecker auf eine gedruckte Schaltung
aufgelötet und in dieser Form ausgeliefert. Die gedruckte Schaltung gestattet das Auffächern der Anschlüsse und damit ein
problemloses Verlöten des Kabels. Auch das Entfernen des Kabels
ist leicht. Der Anschluss ist übersichtlich und das Kabel kann
auf der gedruckten Schaltung gegen Zug gesichert werden.

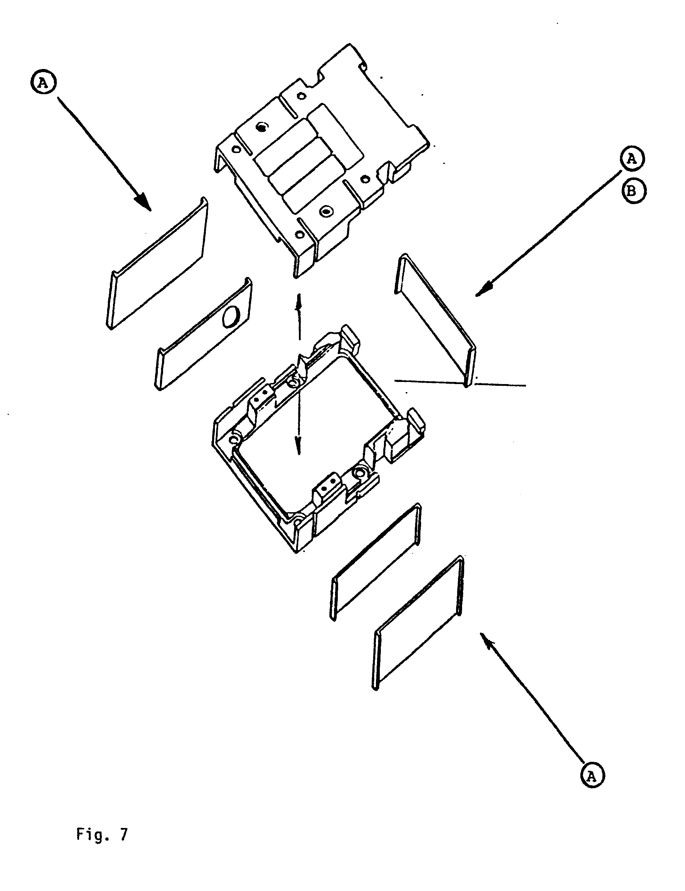

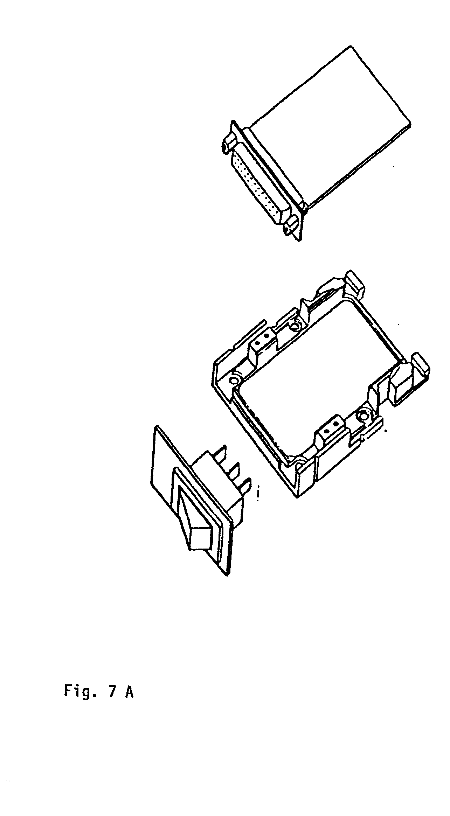

Das obengenannte ist in Figur 7 dargestellt, wobei A für die
verschiedenen Kabelachsen und B für die Möglichkeit, Flachbandkabel in den Stecker einzuführen, steht. Erkennbar sind in
Figur 7 auch die variablen Gehäuseabmessungen.

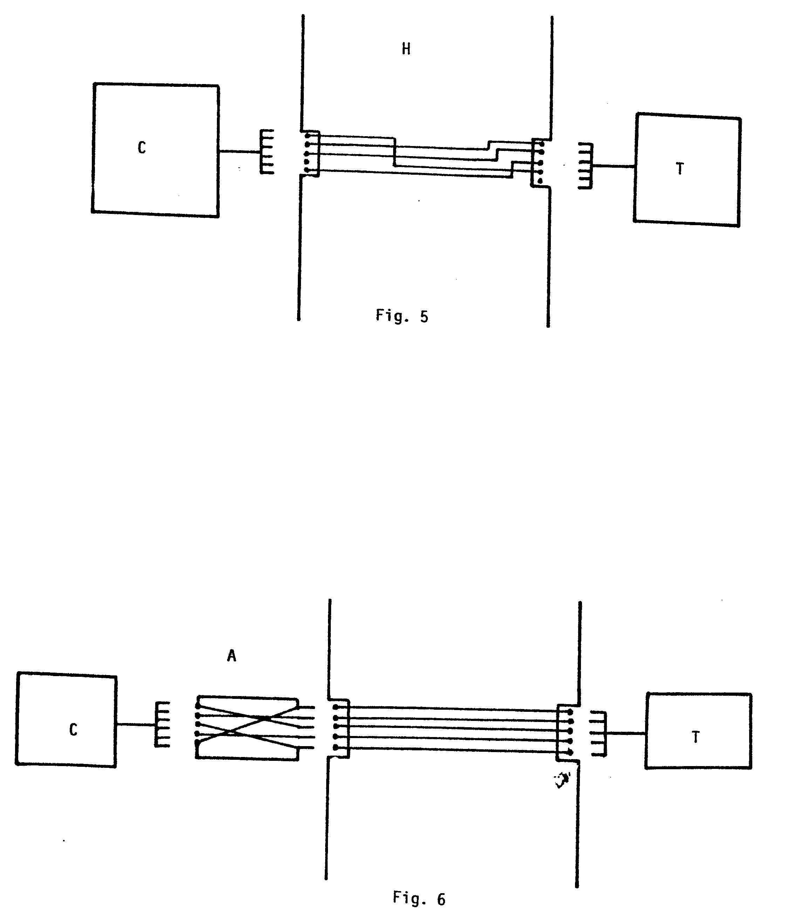

Zur allgemeinen Illustration des neuen Adaptersystems wird
auf die ebenfalls beigelegten Figuren 5 und 6 verwiesen.

Die Figur 5 zeigt ein Beispiel einer Installationsart gemäss dem Stand der Technik.

C steht für (Zentral-)Computer, T für Terminal und H für Hausinstallation. Das Kabel zwischen Computer und Stecker wird Systemkabel, dasjenige zwischen Terminal und dazugehörigem Stecker Terminalkabel genannt. Die Anschlüsse der Hausinstallation sind beidseitig verschieden ausgeführt (siehe oben zu Figuren 1 bis 4).

Die Figur 6 hingegen zeigt eine Installation mit einer Ausführungsform des erfindungsgemässen Adaptersystems. Die Abkürzungen und Bezeichnungen sind dieselben wie in Figur 5, und A steht für Adapter. Die Anschlüsse in der Hausinstallation sind beidseitig gleich ausgeführt.

Der erfindungsgemässe Adapter gestattet die Anwendung eines klaren und einfachen Installationsprinzips zwischen Zentralcomputer und Peripheriegerät.

Dieses Installationsprinzip geht davon aus, dass eine Hausinstallation, die zwischen Computerraum und Terminal nötig wird, auf möglichst einfache Weise und für eine bestimmte Verbindungsart immer gleich ausgeführt werden kann.

Der Installateur musste Steckerbuchsen je nach Verbindungsart auf beiden Seiten verschieden verdrahten. Wird später ein anderes Gerät angeschlossen, muss in den meisten Fällen eine oder beide Steckerbuchsen neu verdrahtet werden.

Der Installateur verdrahtet neu Steckerbuchsen auf beiden Seiten
gleich. Alle Anpassungsfunktionen werden durch die Adapterplatte
übernommen, welche von Fall zu Fall ausgetauscht werden kann.

Im neuen System können Stecker, Steckerbuchsen und Adapter
in gleichen, kombinierbaren Gehäusen untergebracht werden.
Die Verbindung hat, vom Computer bis zum Terminal, System.

Falls Uebertragungsgeräte oder Terminals mit unterschiedlichen
Steckertypen verwendet werden, genügt das Dazwischenschalten
eines entsprechenden Adapters.

Das Gehäuse des erfindungsgemässen Adapters ist so gebaut,
dass es auch gedruckte Schaltungen aufnehmen kann, die beseitig
mit einem Stecker oder Stecker und Buchse verbunden sind. Die
gedruckte Schaltung des Adapters garantiert eine saubere und
fehlerfreie Verbindung, die auf den entsprechenden Fall zugeschnitten ist und keinerlei Anpassungsarbeiten nötig macht.

Adapter-Platten besitzen beidseitig einen Datenstecker, während
Stecker für die Hausinstallation eine Kabelanschlussmöglichkeit
in Form einer gedruckten Schaltung aufweisen. Die Steckerschalen
können mittels Distanzblechen auf beliebige Distanz gebracht
werden, was den Einbau verschiedenster Teile (Schalterelemente
usw.) gestattet. Die Steckergehäuse sind verschraubt und können
flach auf eine Wand oder mittels Gleitschienen senkrecht montiert werden.

Das Gehäuse kann verschiedenste Steckertypen aufnehmen. Wo es die Abmessung des Steckers erfordert, wird dieser in eine
entsprechende Halterung eingelegt.

Das Gehäuse kann Schalter oder andere Elemente wie etwa Kontrollampen aufnehmen. Dazu ist je nach Typ des verwendeten
Elementes eine Halterung in Form eines einfachen Blechteiles
nötig. Siehe dazu Figur 7a.

Das Gehäuse ist so gestaltet, dass es gedruckte Schaltungen
aufnehmen kann.

Das neue Adaptersystem erlaubt den erfolgreichen Aufbau von
Installations-Stützpunkten.

Schwachstrominstallationen - im besonderen in der Computer-
und Datenübertragungstechnik - werden meistens beim Bauen nicht
berücksichtigt. Die Schwachstrominstallation muss also nachträglich den örtlichen und baulichen Gegebenheiten angepasst werden.

Im weiteren muss eine solche Installation eine Sicherheit und
Systematik aufweisen, die in anderen Installationsbereichen
nicht unbedingt erforderlich ist.

Stützpunkte erlauben dem Anwender alle Aspekte von der sicheren
Kabelbefestigung bis hin zur sinnvollen, zweckmässigen Anordnung
mehrerer Elemente zu berücksichtigen.

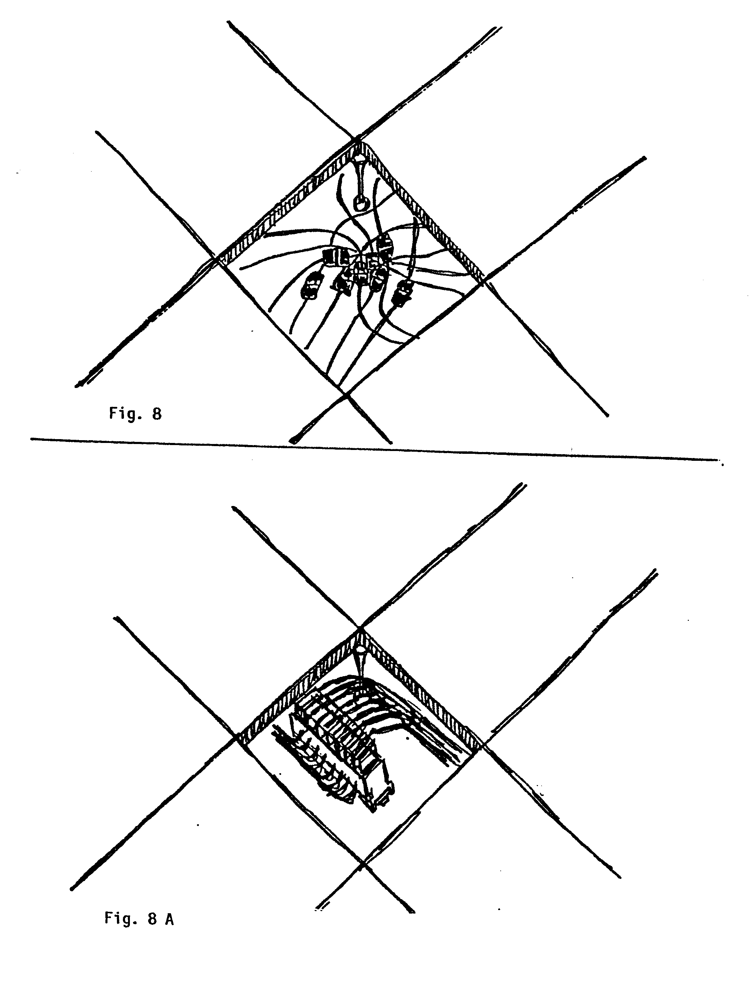

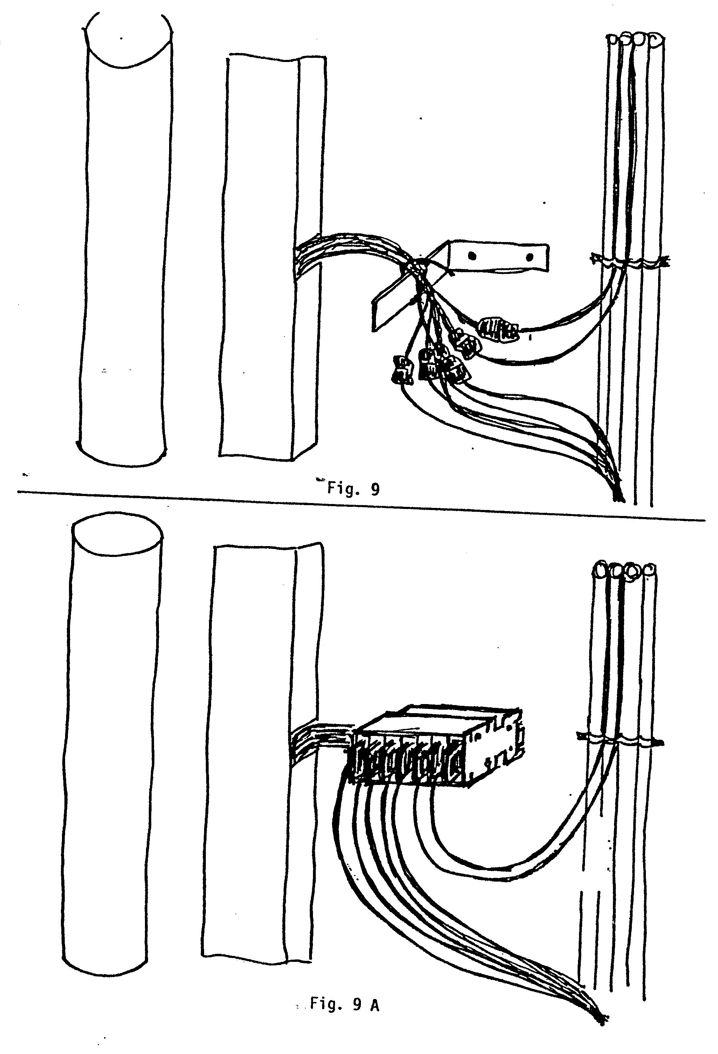

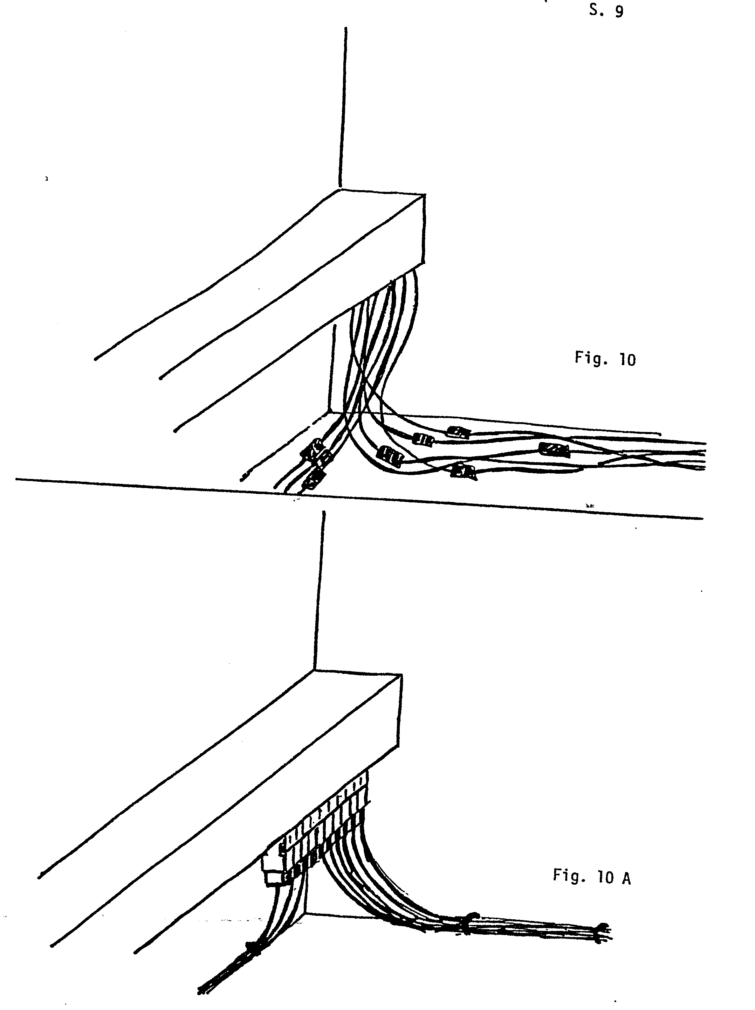

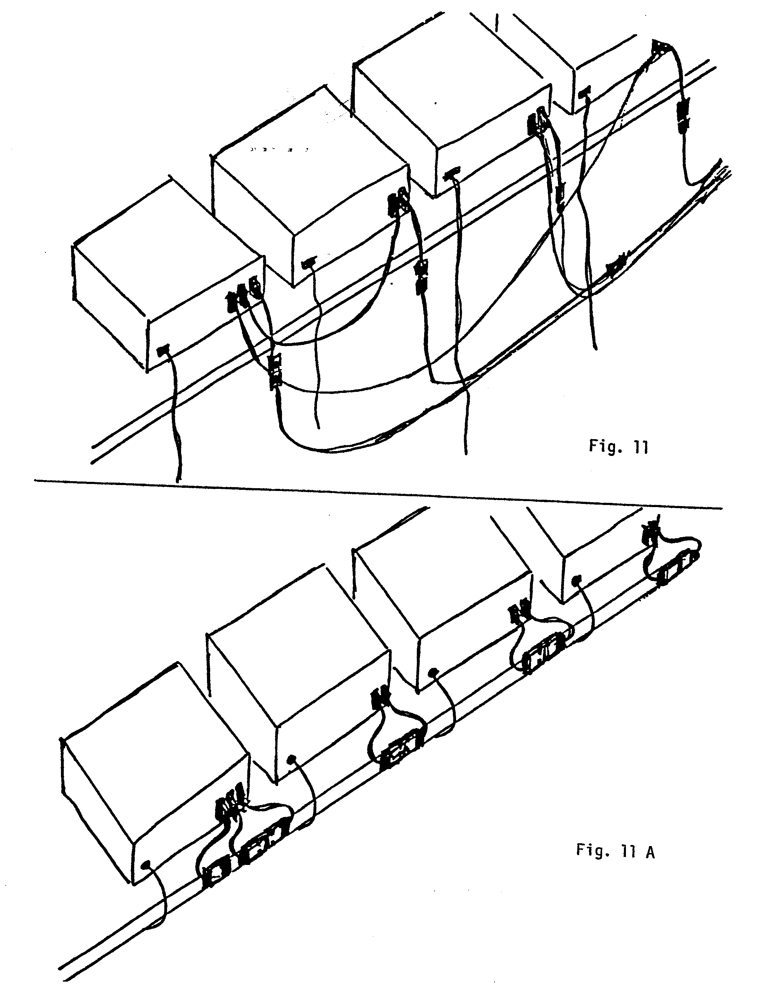

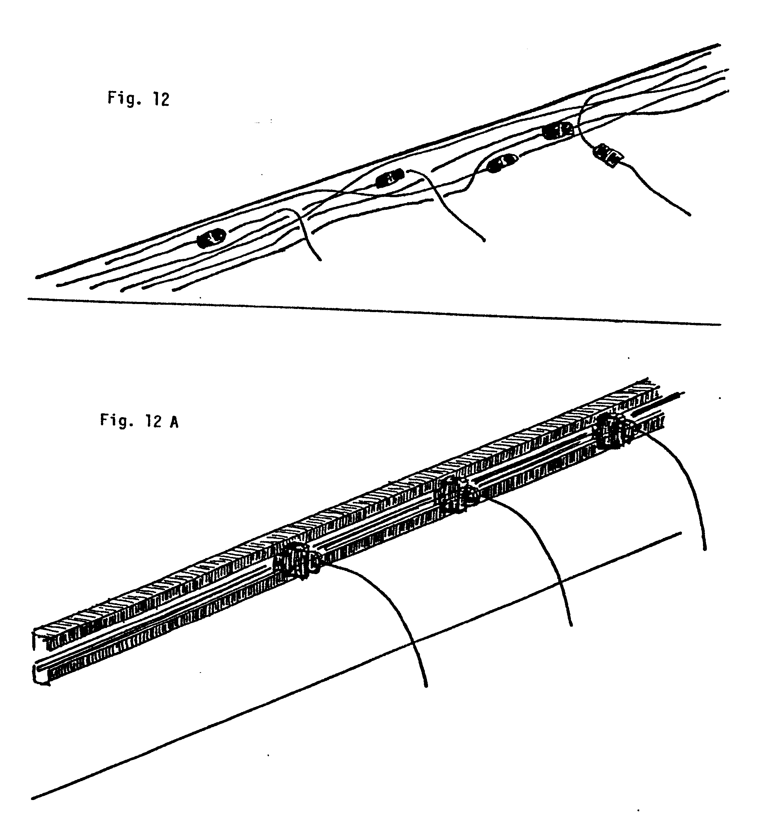

Die Figuren 8 bis 12 zeigen Vergleiche zwischen Installationen gemäss dem Stand der Technik (Figurenziffer ohne A) und entsprechende Installationen erfindungsgemässer Systeme (Figurenziffer mit A).

Die Lagerhaltung des Systems umfasst das Grundsortiment, das nach Anwendungsbereichen aufgeteilt wird und der Auslieferungsstelle aufgrund der Bestellungen - mittels Stücklisten - auf einfache Weise eine grosse Verfügbarkeit mit minimalen Lagerbeständen gestattet.

Sollten die Standard-Programme für die Lösung von speziellen Installationsproblemen nicht ausreichen, können das entsprechende Rohmaterial oder die Halbfabrikate an Lager genommen werden.

Dies betrifft vor allem Aluminium-Blechteile, welche somit auf die gewünschten Dimensionen zugeschnitten und bearbeitet werden können, wie auch die Befestigungs- und Kabelführungsprofile.

Durch die Installation von Anlagen mit dem erfindungsgemässen Adaptersystem ist man der "Computerleistung aus der EDV-Steckdose" einen wesentlichen Schritt näher gekommen.

PA 84/40

## PATENTANSPRUECHE

1. Adaptersystem zur Herstellung einer gesicherten Datenübertragungsverbindung zwischen Zentralcomputer und Peripheriegeräten, bestehend im wesentlichen aus den Elementen Gerätestecker auf Seite Hausinstallation, Steckdose auf Seite Computer sowie, im üblichen Falle, Adapter zwischen den beiden genannten Elementen, dadurch gekennzeichnet,

dass Steckdosen- und Adapterelement in Gehäusen untergebracht sind, welche in zwei der drei Raumdimensionen in allen Fällen klassengleich und in der dritten Dimension variabel sind,

2

dass Steckdosen- und Adaptergehäuse verschiedene Datenstekker bzw. -steckdosen aufnehmen,

dass der Adapter derart in die Hausinstallation eingebaut
wird, dass er vorgeschaltet bzw. vorgesteckt wird,

dass der Adapter genau auf das Peripheriegerät abgestimmt
und fest verkabelt ist und beidseitig Datenstecker/-steckdose
aufweist und

dass die im System verwendeten Stecker bzw. Steckdosen über
eine gedruckte Schaltung mittels Löten an Kabeln angeschlossen werden.

2. Adaptersystem gemäss Patentanspruch 1, dadurch gekennzeichnet,

dass der Adapter ein Gehäuse aus zwei formgleichen Schalen,
welche aus Kunststoff hergestellt sind, aufweist,

dass die Seitenteile des genannten Gehäuses austauschbar
sind und einerseits das Volumen des Gehäuses zu variieren,
andererseits eine Anpassung an den jeweiligen Verwendungszweck
gestatten,

dass die Abmessungen und die Formgebung des genannten Gehäuses
mit bestehenden Steckersystemen und Befestigungseinrichtungen
harmonieren, wobei als Vertiefungen ausgebildete Felder,
die für Beschriftungen vorgesehen sind, herausgebrochen
werden können, so dass ein Gehäusedurchbruch entsteht,

dass das Gehäuse durch Schrauben, Federklammern oder die

3

0179159

Klemmteile der Befestigungsschiener. zusammengehalten wird,

dass, um elektronische Schaltungen und Komponenten von äusseren Störeinflüssen zu schützen, das Gehäuse mit einer Schirmfolie ausgelegt ist oder die Kunststoffteile galvanisch metallisiert sind und

dass, um die Kabelzuführung möglichst flexibel zu gestalten, die Einführungsachse von drei Seiten wählbar ist, wobei durch die Rückseite auch Flachbandkabel eingeführt werden können.

3. Adaptersystem gemäss Patentanspruch 1, dadurch gekennzeichnet, dass Steckdosen- und Adaptergehäuse aus zwei galvanisierbaren Kunststoffschalen bestehen, die mittels Distanzblechen in verschiedenen Breiten fixiert werden, wodurch der Einbau von weiteren Elektronik-Bauelementen ermöglicht wird.

4. Adaptersystem gemäss Patentanspruch 1 oder 2, dadurch gekennzeichnet, dass das Gehäuse der Steckdose Seite Computer und des Adapters derart ausgebildet ist, dass es einzeln oder in Serien entweder an der Wand, in waagrechten oder senkrechten Schienen oder, bei Bedarf, auch in Aufputz- oder Unterputzmontage angebracht bzw. verschraubt oder eingeklemmt werden kann.

5. Verwendung des Adaptersystems gemäss Patentanspruch 1 zur Herstellung von Datenübertragungsverbindungen in gebäudein-

4

0179159

ternen oder -externen EDV-Anlagen zwischen einem oder mehreren Zentralcomputern und mehreren Terminalgeräten.

Fig. 1

A

B

C

D

Fig. 2

Fig. 3

Fig. 4

H

C

T

Fig. 5

A

C

T

Fig. 6

Ⓐ

Ⓐ
Ⓑ

Ⓐ

Fig. 7

Fig. 7 A

Fig. 8

Fig. 8 A

Fig. 9

Fig. 9 A

Fig. 10

Fig. 10 A

Fig. 11

Fig. 11 A

Fig. 12

Fig. 12 A

Europäisches
Patentamt

EUROPÄISCHER RECHERCHENBERICHT

Nummer der Anmeldung

0179159

EP 84 11 2687

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | GB-A-2 115 989 (SMITH u.a.) <br> * Figuren; Seite 1, Zeile 29 - Seite 2, Zeile 16 * <br> --- | 1,4,5 | G 06 F 13/40 <br> H 05 K 5/04 |
| A | WO-A-8 400 644 (WILLENBORG) <br> * Figuren 1,2; Seite 2, Zeile 11 - Seite 3, Zeile 21; Seite 4, Zeilen 16-28 * <br> --- | 1-4 | |
| A | US-A-3 705 378 (ELKINS) <br> * Figuren 2,4,5; Spalte 2, Zeile 20 - Spalte 3, Zeile 68 * <br> --- | 1-5 | |
| A | IBM TECHNICAL DISCLOSURE BULLETIN, Band 14, Nr. 1, Juni 1971, Seiten 120-121, New York, US; K.J. ODEEN: "Cable adapter" <br> * Insgesamt * <br> --- | 1 | |
| A | ELECTRICAL DESIGN NEWS, Band 27, Nr. 2, Januar 1982, Seiten 158-159, Boston, US; R. TENNY: "RS-232 cable suits multifunction use" <br> * Insgesamt; Figur 2 * <br> --- | 3 | RECHERCHIERTE SACHGEBIETE (Int. Cl.4) <br><br> G 06 F 13/40 <br> H 01 R <br> H 05 K <br> H 02 G <br> H 01 T |
| A | GB-A-1 497 560 (BARNETT Jr. u.a.) <br> * Figuren 1,2; Seite 1, Zeilen 14-67 * <br> --- | 2 | |
| A | DE-A-2 031 734 (WOLPERT) <br> * Figuren 1-3; Seite 1, Zeile 9 - Seite 4, Zeile 31 * <br> --- | 1,2,4 | |

Der vorliegende Recherchenbericht wurde für alle Patentansprüche erstellt.

| Recherchenort <br> DEN HAAG | Abschlußdatum der Recherche <br> 21-02-1985 | Prüfer <br> QUESSON C.J. |
|---|---|---|